# EUROPEAN PATENT APPLICATION

(11) **EP 4 765 173 A1**
(43) Date of publication of application: **24.06.2026**
(21) Application number: 25215636.9
(22) Date of filing: 13.11.2025
(51) Int. Cl.: H01F 27/28, H01F 38/14, H02J 50/12, H01G 4/40, H05K 1/16

(54) **COIL STRUCTURE**

(30) Priority: 20.12.2024 US 202463736613 P; 09.07.2025 TW 114126050
(71) Applicant: Voltraware Semiconductor Co., LTD., 235 New Taipei City (TW)
(72) Inventor: HSU, Jr Uei, 235 New Taipei City (TW); HUANG, Pei-Wei, 235 New Taipei City (TW); HUANG, Cheng Yang, 235 New Taipei City (TW); HSU, Tzu Yu, 235 New Taipei City (TW); HUNG, Ming Shun, 235 New Taipei City (TW); SHEN, Yu Hao, 235 New Taipei City (TW)
(74) Representative: Mitola, Marco

(57) **Abstract**

A coil structure applied in the field of wireless charging comprises a circuit board and a conductor. The conductor is arranged on the circuit board. The conductor comprises a plurality of coil turns, an input terminal, an output terminal, and a plurality of first capacitor structures. The coil turns are formed around a center point. The input terminal is connected to a one terminal of the coil turns. The outlet terminal is connected to another terminal of the coil turns. Each of the first capacitor structures is arranged on a corresponding one of the coil turns. Distance between the first capacitor structures and the output terminal is smaller than a distance between the first capacitor structures and the input terminal, and the first capacitor structures do not overlap with the output terminal.

## Description

### BACKGROUND

### Field of Invention

This disclosure relates to a coil structure, and in particular to the coil structure having capacitor structures arranged on coil turns.

### Description of Related Art

In the field of wireless charging, electromagnetic resonance is a commonly used principle. A wireless charging system utilizing electromagnetic resonance typically comprises a transmitter and a receiver. Both the transmitter and the receiver utilize coil structures to transfer electromagnetic energy to achieve the purpose of charging.

How to reduce energy loss of the coil structure and increase the magnetic field strength thereof, to enhance the electromagnetic energy transfer between the transmitter and the receiver, are important issues the technicians in this field must deal with.

### SUMMARY

The present disclosure provides a coil structure applied in the field of wireless charging. The coil structure comprises a circuit board and a conductor. The conductor is arranged on the circuit board. The conductor comprises a plurality of coil turns, an input terminal, an output terminal, and a plurality of first capacitor structures. The coil turns are formed around a center point. The input terminal is connected to a one terminal of the coil turns. The outlet terminal is connected to another terminal of the coil turns. Each of the first capacitor structures is arranged on a corresponding one of the coil turns. The distance between the first capacitor structures and the output terminal is smaller than the distance between the first capacitor structures and the input terminal, and the first capacitor structures do not overlap with the output terminal.

The present disclosure provides a wireless charging device. The wireless charging device comprises a coil structure configured for wireless charging. The coil structure comprises a circuit board and a conductor. The conductor is arranged on the circuit board. The conductor comprises a plurality of coil turns, an input terminal, an output terminal, and a plurality of first capacitor structures. The coil turns are formed around a center point. The input terminal is connected to a one terminal of the coil turns. The output terminal is connected to another terminal of the coil turns. Each of the first capacitor structures is arranged on a corresponding one of the coil turns. The distance between the first capacitor structures and the output terminal is smaller than the distance between the first capacitor structures and the input terminal, and the first capacitor structures do not overlap with the output terminal.

In summary, when the coil structure of the present disclosure is used in wireless charging, the electric field intensity thereof can be reduced, thereby suppressing stray electric fields caused by parasitic capacitance, reducing the temperature rise of the coil structure, and improving magnetic field stability. Therefore, a wireless charging device including the coil structure can achieve higher charging efficiency.

### BRIEF DESCRIPTION OF THE DRAWINGS

Fig. 1A is a schematic diagram of a coil structure according to an embodiment of the present disclosure.
Fig. 1B is a schematic diagram of a conductor according to an embodiment of the present disclosure.
Fig. 2A is a schematic diagram of a conductor according to an embodiment of the present disclosure.
Fig. 2B is a schematic diagram of a capacitor structure according to an embodiment of the present disclosure.
Fig. 2C is a schematic diagram of a capacitor structure according to an embodiment of the present disclosure.
Fig. 2D is a schematic diagram of a capacitor structure according to an embodiment of the present disclosure.
Fig. 3 is a schematic diagram of a coil structure according to an embodiment of the present disclosure.
Fig. 4A is a schematic diagram of a capacitor structure and an additional capacitor structure according to an embodiment of the present disclosure.
Fig. 4B is a schematic diagram of a capacitor structure and an additional capacitor structure according to an embodiment of the present disclosure.

### DETAILED DESCRIPTION

The terms used in the entire specification and the scope of the patent application, unless otherwise specified, generally have the ordinary meaning of each term used in the field, the content disclosed herein, and the particular content.

The terms "coupled" or "connected" as used herein may mean that two or more elements are directly in physical or electrical contact or are indirectly in physical or electrical contact with each other. It can also mean that two or more elements interact with each other.

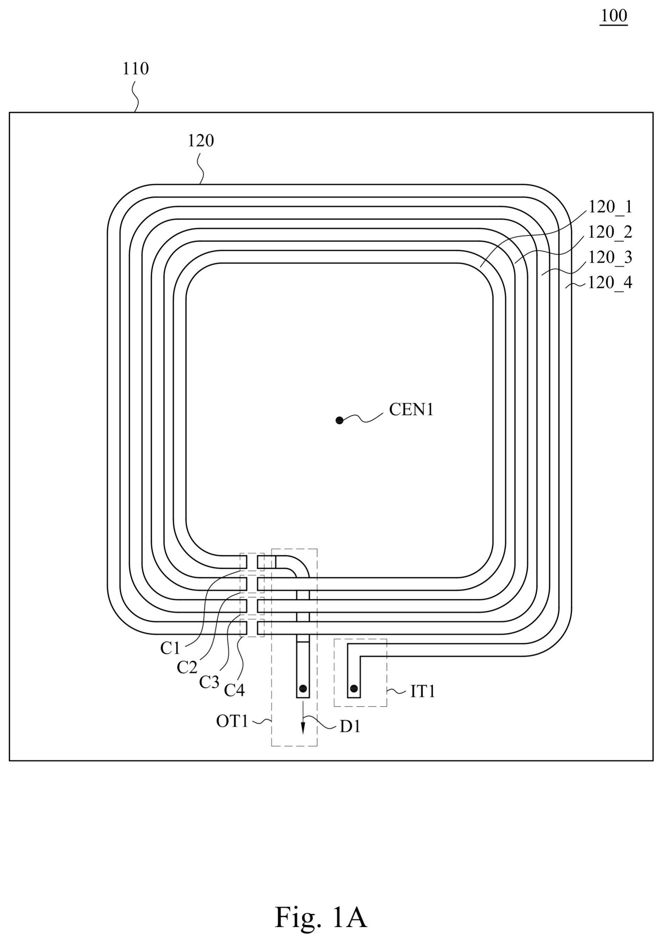

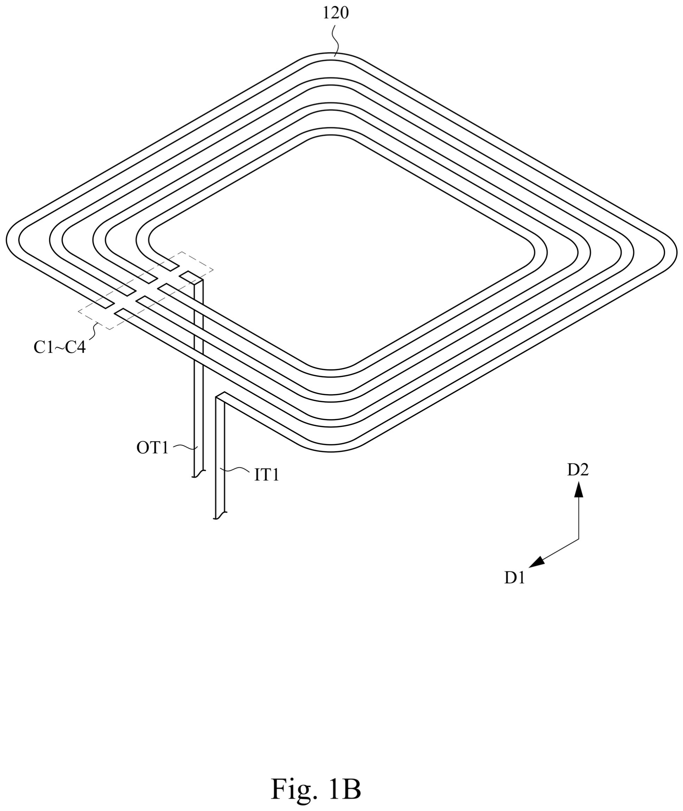

Referring to Figs. 1A and 1B, Fig. 1A is a schematic diagram of a coil structure according to an embodiment of the present disclosure, Fig. 1B is a schematic diagram of a conductor according to an embodiment of the present disclosure.

The coil structure 100 may be arranged in a wireless charging device. The wireless charging device can be applied to any type of electrical equipment that requires power transfer, such as rail-guided or rail-free automated guided vehicles (AGVs), unmanned aerial vehicles (UAVs), and other autonomous vehicles for wireless charging. The wireless charging device and the autonomous vehicle may be applied in special environments that are difficult for personnel to reach, such as deep-sea, desert, or vacuum environments. This reduces the risk to personnel by eliminating the need for manual operation of wired connectors to charge the equipment, allowing machines to automatically move into a charging range, achieving a fully automated environment, and enabling continuous automated operation of the equipment. Furthermore, the wireless charging device can use the coil structure 100 to transfer energy to a target object (e.g., the AGV mentioned above) through electromagnetic resonance. In some embodiments, the wireless charging device may operate at a resonance frequency of 6.78 MHz to achieve the electromagnetic resonance charging mentioned above.

Specifically, the principle of electromagnetic resonance wireless charging technology is to provide a power transmitter (e.g., the coil structure 100) and a receiver (e.g., a charging coil turn built into the AGV mentioned above) both with resonant coil turns tuned to the same resonance frequency. Without physical contact, the energy is transferred through a magnetic resonance coupling mechanism, thereby improving wireless charging efficiency over medium and long distances.

The coil structure 100 may be arranged at either the transmitting terminal or the receiving terminal of a wireless charging device. The coil structure 100 comprises a circuit board 110 and a conductor 120. The circuit board 110 may be a fixed medium, such as a printed circuit board (PCB). The conductor 120 may be wound around a position (e.g., the center point CEN1 in FIG. 1A) to form a plurality of coil turns and may be fixed in position on the circuit board 110.

The shape of the conductor 120 may be circular, quadrilateral, octagonal, or any other shape, and can be adjusted according to different usage scenarios. The amount of the coil turns is not limited (e.g., 4, 8, 16, 32, etc.). The conductor 120 in Fig. 1A is a quadrilateral and has coil turns 120_1-120_4 only for the convenience of illustrating the configuration of the coil structure 100, but it does not indicate that the conductor 120 must be quadrilateral or the amount of coil turns must be four. The conductor 120 may comprise an input terminal IT1 and an output terminal OT1. The input terminal IT1 and the output terminal OT1 are respectively connected to the two terminals of the conductor 120, configured to let the current flow through the plurality of coil turns. The input terminal IT1 may be connected to one terminal of the plurality of coil turns (e.g., the outermost coil turn). The output terminal OT1 may be connected to the other terminal of the plurality of coil turns (e.g., the innermost coil turn).

In some embodiments, the input terminal IT1 is connected to the coil turn 120_4 and extends along a first direction D1, as shown in Fig. 1A. In these embodiments, the output terminal OT1 is connected to the coil turn 120_1, passes through the coils 120_1-120_4 from the bottom of the coils, and extends along the first direction D1, or outwardly from the innermost coil to the outermost coil.

In other embodiments, the input terminal IT1 is connected to coil turn 120_4 and extends along a second direction D2 which is perpendicular to the first direction D1, as shown in Fig. 1B. In these embodiments, the output terminal OT1 is connected to coil turn 120_1 and likewise extends along the second direction D2. Assuming the coil turns 120_1-120_4 are arranged on a first plane in space, the second direction D2 may be considered perpendicular to the first plane.

In further embodiments, the input terminal IT1 may extend along the first direction D1, and the output terminal OT1 may extend along the second direction D2 (not shown). Each of the plurality of coil turns of the conductor 120 may arrange at least one capacitor structure. In the embodiment of Fig. 1A, first capacitor structures C1-C4 are respectively arranged on the coil turns 120_1-120_4. Each of the coil turns may comprise at least one dielectric material such, such as paper, nylon, polystyrene, Teflon, ceramic, silicon, silicone oil, etc. If the dielectric material is non-solid (e.g., air) or liquid, a gap may be formed on the coil turns. The gaps may correspondingly form the first capacitor structures C1-C4. The first capacitor structures C1-C4 and the coil turns 120_1-120_4 may be integrally formed.

As shown in Fig. 1A, the first capacitor structures C1-C4 may be aligned along the first direction D1. The distance between the first capacitor structures C1-C4 and the output terminal OT1 is smaller than the distance between the first capacitor structures C1-C4 and the input terminal IT1. Moreover, the arranged positions of the first capacitor structures C1-C4 on the coil turns do not overlap with the position of the output terminal OT1 extending from each of the coil turns.

When the current flows through the coil structure 100, the arrangement of the first capacitor structures C1-C4 between the coil turns 120_1-120_4 can effectively reduce the parasitic capacitance coupling effects between the coil turns, thereby suppressing the stray electric fields caused by parasitic capacitance. This may significantly reduce the electric field intensity of the coil structure 100, achieving field concentration and uniform electric field distribution. The first capacitor structures C1-C4 may further form inductance-capacitance resonance (LC resonance) loop with the coil turns, enabling the coil structure 100 to have a higher quality factor (Q factor), which helps improve energy focusing efficiency and magnetic field stability.

In a preferred embodiment, when the first capacitor structures C1-C4 are arranged near the output terminal OT1, since the current flows from the input terminal IT1 toward the output terminal OT1, the parasitic voltage drop and localized electric field concentration may easily occur in the conductor path, resulting in increasing the dielectric loss and potential radiation loss in that region. By arranging the capacitors in this region, local impedance can be effectively adjusted, excessive voltage drops can be released, and electric field peaks can be suppressed. Moreover, this may form a transmission channel with stable electric field distribution and good impedance matching, thereby reducing overall power loss and improving wireless power transmission efficiency.

Furthermore, through the resonant connection formed by the inductance and the first capacitor structures C1-C4, high-efficiency energy coupling can be achieved, and coil structure 100 can also serve as a passive filter with frequency selectivity. The passive filter can transmit energy at the target resonance frequency while suppressing high-frequency noise and sub-harmonic components in non-resonant frequency bands, and it can effectively filter stray electromagnetic waves caused by switching actions, harmonic reflections, or external radio frequency interference (RFI). Through the filter effect mentioned above, the field control of the wireless charging device during operation can be more centralized and stable, the resonant coupling efficiency between the main magnetic field and the receiving coil turns can be improved, and the anti-interference ability of the system in high-frequency operating environments can be enhanced in practical applications. Furthermore, since the overall resistance loss and eddy current loss of the coil structure 100 are simultaneously reduced, the overall power consumption is reduced, the energy retention rate and transmission efficiency of the device are further improved. In summary, the resonant structure of the coil turns, and capacitor of the present disclosure has multiple functions such as energy coupling enhancement, electric field distribution suppression and filtering and anti-interference, and is suitable for high-efficiency and stable wireless power transmission applications.

It is worth mentioning that in some embodiments, the first capacitor structures C1-C4 have an identical capacitance value, thereby simplifying the manufacturing process and reducing the cost of manufacturing the coil structure 100.

In other embodiments, the first capacitor structures C1-C4 have different capacitance values. Specifically, the capacitance values of the first capacitor structures C1-C4 decrease sequentially from the innermost capacitor structure to the outermost capacitor structure arranged on the coil turns 120_1-120_4. That is, the capacitance values of the first capacitor structures C1-C4 are as follows from large to small: the first capacitor structure C1, the first capacitor structure C2, the first capacitor structure C3, and the first capacitor structure C4.

Comparing to the capacitor structures with the identical capacitance value, when the first capacitor structures C1-C4 have different capacitance values that sequentially decrease from the innermost capacitor structure to the outermost capacitor structure, the electric field distribution on coil turns 120_1-120_4 can be effectively adjusted, thereby achieving a better filtering effect and preventing excessive local electric fields in coil structure 100 from causing energy loss. Furthermore, by arranging capacitors with different capacitance values, the local electromagnetic resonance frequency of the coil turns 120_1-120_4 can be fine-tuned, making the overall magnetic field of coil structure 100 more stable. This may facilitate concentrating energy on the magnetic field transmission in the wireless charging device, thereby enhancing the quality factor of the coil structure 100 and improving charging efficiency.

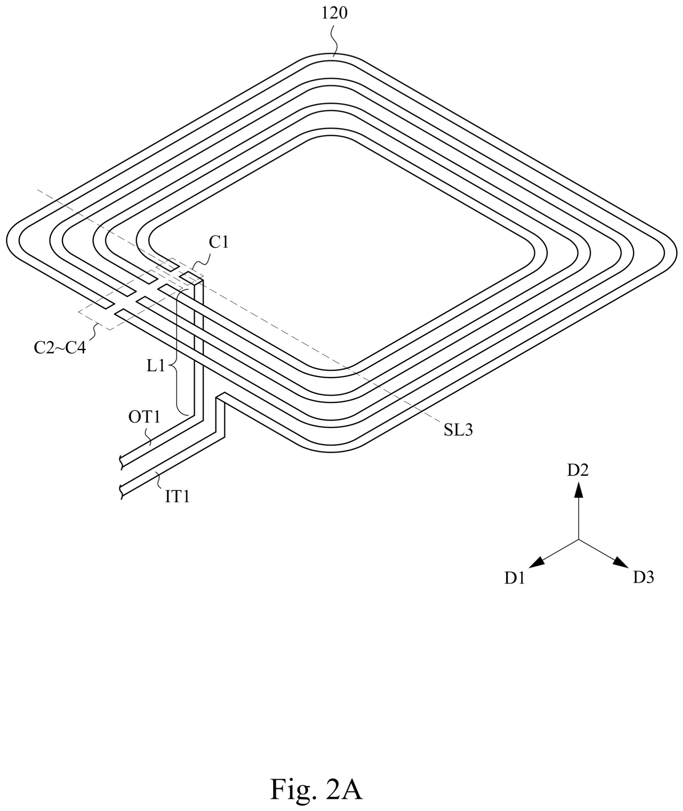

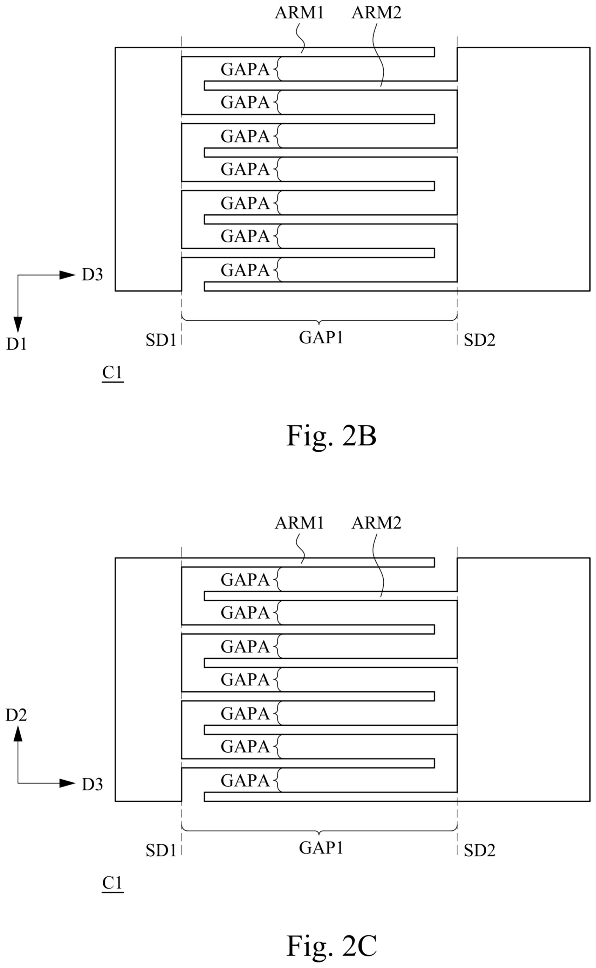

Referring to Figs. 2A-2D, Fig. 2A is a schematic diagram of a conductor 120 according to an embodiment of the present disclosure. Figs. 2B-2D are schematic diagrams of the first capacitor structure C1 according to different embodiments of the present disclosure.

The conductor 120 in Fig. 2A may correspond to the conductor 120 in Fig. 1A. The conductor 120 in Fig. 2A is also arranged on the circuit board 110.

In Fig. 2A, three different directions are indicated: a first direction D1, a second direction D2, and a third direction D3. The first direction D1, the second direction D2, and the third direction D3 are perpendicular to each other and may be regarded as the three axes of three-dimensional space. The plurality of coil turns of the conductor 120 are arranged on the first plane, which is a two-dimensional plane defined by the first direction D1 and the third direction D3. The input terminal IT1 and the output terminal OT1 are both at a length L1 from the plurality of coil turns along the second direction D2, and both extend along the first direction D1.

In various embodiments of the present disclosure, each of the first capacitor structures C1-C4 has a similar structure. Figs. 2B-2D discloses the structure of the first capacitor structure C1 in different embodiments. The first capacitor structures C2-C4 may correspond to the following contents of the first capacitor structure C1.

In Fig. 2B, the first capacitor structure C1 comprises a plurality of first connecting arms ARM1 and a plurality of second connecting arms ARM2. Each of the first connecting arms ARM1 extends from a first side SD1 of a first gap GAP1, and each of the second connecting arms ARM2 extends from a second side SD2 of the first gap GAP1. The length of each first connecting arm ARM1 and the length of each second connecting arm ARM2 are less than the distance from the first side SD1 to the second side SD2 of the first gap GAP1. The first connecting arms ARM1 and the second connecting arms ARM2 are alternately arranged. A distance between each first connecting arm ARM1 and an adjacent second connecting arm ARM2 is defined as a first spacing GAPA. The first connecting arms ARM1 and the second connecting arms ARM2 may function as capacitor elements in the coil structure 100.

In some embodiments, all the first spacings GAPA between the plurality of first connecting arms ARM1 and the plurality of second connecting arms ARM2 have the same width.

In other embodiments, the plurality of first spacings GAPA may have different widths depending on different usage requirements. In other words, the distances between the first connecting arms ARM1 and the second connecting arms ARM2 may be different. By providing the first spacings GAPA with different widths, the first capacitor structure C1 may have different capacitance values.

It is worth noting that, in the embodiment of Fig. 2B, the circuit board 110 is arranged on the first plane defined by the first direction D1 and the third direction D3, and each of the first connecting arms ARM1 and each of the second connecting arms ARM2 are alternately arranged on the first plane.

The first capacitor structure C1 in Fig. 2C, like the first capacitor structure C1 in Fig. 2B, comprises a plurality of first connecting arms ARM1 and a plurality of second connecting arms ARM2. In Fig. 2C, each of the first connecting arms ARM1 and each of the second connecting arms ARM2 are also alternately arranged.

The difference is that the first connecting arms ARM1 and the second connecting arms ARM2 in Fig. 2C are alternately arranged along the second direction D2 perpendicular to the first plane. Fig. 2A shows a section line SL3 extending along a third direction D3, and Fig. 2C is a cross-sectional view diagram of the first capacitor structure C1 in Fig. 2A along the section line SL3.

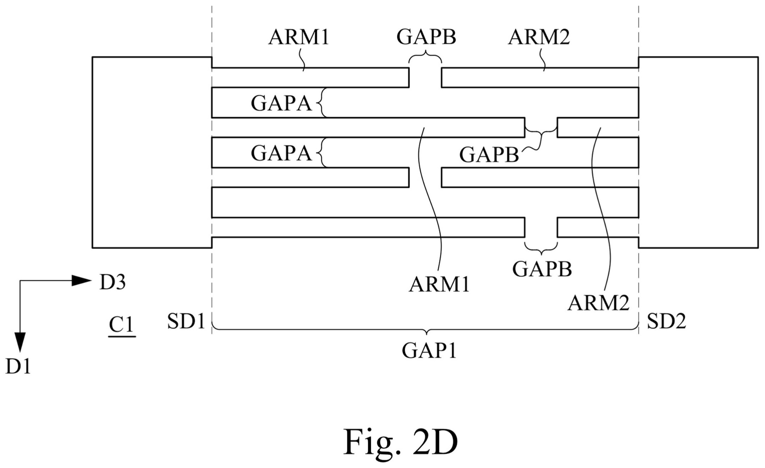

In Fig. 2D, the first capacitor structure C1 also comprises a plurality of first connecting arms ARM1 and a plurality of second connecting arms ARM2, and the first connecting arms ARM1and the second connecting arms ARM2 may function as capacitor elements.

Each of the first connecting arms ARM1 extends from the first side SD1 of the first gap GAP1, and each of the second connecting arms ARM2 extends from the second side SD2 of the first gap GAP1.

Adjacent two of the first connecting arms ARM1 are spaced apart by the first spacing GAPA, and adjacent two of the second connecting arms ARM2 are spaced apart by the first spacing GAPA. Each of the first connecting arm ARM1 is aligned with a corresponding second connecting arm ARM2 along the third direction D3 and spaced apart by a second spacing GAPB. Specifically, sum of the length of each first connecting arm ARM1, the length of the corresponding second connecting arm ARM2, and the length of the second spacing GAPB equals the length of the first gap GAP1.

The second spacing GAPB between each of the first connecting arms ARM1 and the corresponding one of the second connecting arms ARM2 is not aligned with the second spacing GAPB between an adjacent one of the first connecting arms ARM1 and another corresponding one of the second connecting arms ARM2 along the first direction D1. That is, any two adjacent second spacings GAPB are not aligned in the first direction D1.

In some embodiments, lengths of adjacent two of the first connecting arms ARM1 may be different, and lengths of adjacent two of the second connecting arms ARM2 may also be different, so that the adjacent second spacings GAPB are alternately arranged rather than aligned.

It is worth noting that, in the embodiment of Fig. 2D, the circuit board 110 is arranged on the first plane defined by the first direction D1 and the third direction D3, and the second spacings GAPB between the first connecting arms ARM1 and the second connecting arms ARM2 are alternately arranged on the first plane.

In other embodiments, the plurality of second spacings GAPB separating the first connecting arm ARM1 and the second connecting arm ARM2 are alternately arranged along the second direction D2, and the second direction D2 is perpendicular to the first plane. In these embodiments, FIG. 2D can be regarded as a cross-sectional view diagram of the first capacitor structure C1 in Fig. 2A along section line SL3.

Across the embodiments in Figs. 2B-2D, the structure of the connecting arms in these embodiments can effectively disperse the electric field in the coil structure, reduce the local voltage in the coil, and thus suppress the formation of hot spots and avoid local concentration of the electric field.

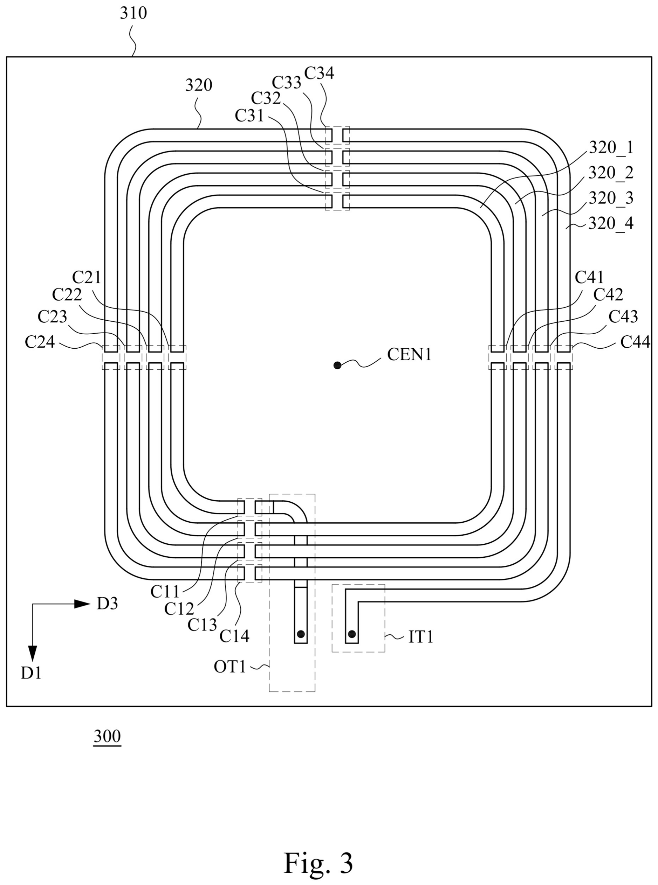

Referring to Figs. 1A and 3, Fig. 3 is a schematic diagram of a coil structure 300 according to an embodiment of the present disclosure. The coil structure 300 comprises a circuit board 310 and a conductor 320. Comparing to the coil structure 100 in Fig. 1, the circuit board 310 has the same characteristics as the circuit board 110 in Fig. 1A, but the conductor 320 is different from the conductor 120 in that a greater amount of capacitor structures are provided on coil turns 320_1-320_4.

The conductor 320 may comprise first capacitor structures C11-C14, second capacitor structures C21-C24, third capacitor structures C31-C34, and fourth capacitor structures C41-C44. These capacitor structures are arranged at different positions along the coil turns 320_1-320_4. The amount of the capacitor structures on the conductor 320 is not limited and may vary depending on usage requirements.

In the embodiment of Fig. 3, the conductor 320 is quadrilateral and may be divided into four sides. The first capacitor structures C11-C14, along with the output terminal OT1 and the input terminal IT1, may be arranged on the first side of the conductor 320 (the down side in Fig. 3). The second capacitor structures C21-C24 may be arranged on a second side (the left side in Fig. 3), the third capacitor structures C31-C34 on a third side (the upper side in Fig. 3), and the fourth capacitor structures C41-C44 on a fourth side (the right side in Fig. 3).

In this embodiment, the first direction D1 and the third direction D3 are perpendicular to each other, and the circuit board 310 is arranged on the first plane defined by the first direction D1 and the third direction D3. The first capacitor structures C11-C14 may be aligned along the first direction D1, the second capacitor structures C21-C24 may be aligned along the third direction D3, the third capacitor structures C31-C34 may be aligned along the first direction D1, and the fourth capacitor structures C41-C44 may be aligned along the third direction D3. The first capacitor structures C11-C14 and the fourth capacitor structures C41-C44 do not need be aligned with each other.

The first capacitor structure C11, the second capacitor structure C21, the third capacitor structure C31, and the fourth capacitor structure C41 arranged on the coil 320_1 can have an identical capacitance value; the first capacitor structure C12, the second capacitor structure C22, the third capacitor structure C32, and the fourth capacitor structure C42 arranged on the coil 320_2 can have an identical capacitance value; the first capacitor structure C13, the second capacitor structure C23, the third capacitor structure C33, and the fourth capacitor structure C43 arranged on the coil 320_3 can have an identical capacitance value; the first capacitor structure C14, the second capacitor structure C24, the third capacitor structure C34, and the fourth capacitor structure C44 arranged on the coil 320_4 can have an identical capacitance value.

In some embodiments, the first capacitor structures C11-C14 have identical capacitance value. That is, the first capacitor structures C11-C14, the second capacitor structures C21-C24, the third capacitor structures C31-C34, and the fourth capacitor structures C41-C44 all have the same capacitance value.

In other embodiments, the first capacitor structures C11-C14 have different capacitance values. The capacitance values of the first capacitor structures C11-C14 decrease sequentially from the innermost capacitor structure to the outermost capacitor structure arranged on the coil turns 320_1-320_4. The capacitance values of the capacitor structures on the conductor 320 are as follows from largest to smallest: the first capacitor structure C11 (same as the second capacitor structure C21, the third capacitor structure C31, and the fourth capacitor structure C41), the first capacitor structure C12 (same as the second capacitor structure C22, the third capacitor structure C32, and the fourth capacitor structure C42), the first capacitor structure C13 (same as the second capacitor structure C23, the third capacitor structure C33, and the fourth capacitor structure C43), and the first capacitor structure C14 (same as the second capacitor structure C24, the third capacitor structure C34, and the fourth capacitor structure C44).

Compared to the coil structure 100 of Fig. 1A, each of the coils turns 320_1-320_4 in Fig. 3 has four capacitor structures. This prevents the concentration of the electric fields on a single capacitor structure in the coil turns 320_1-320_4, but rather make the electric fields evenly distributed across the first through the fourth capacitor structures. As a result, the coil structure 300 can further reduce the factor of excessive local electric fields, so that the energy loss caused by the coil structure 300 can be lower than the energy loss caused by the coil structure 100. In other words, the quality factor and the charging efficiency of the coil structure 300 can be further improved.

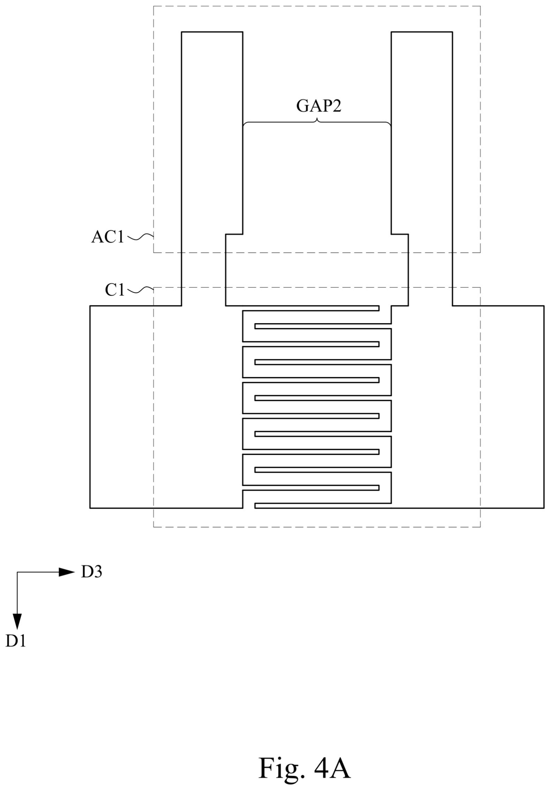

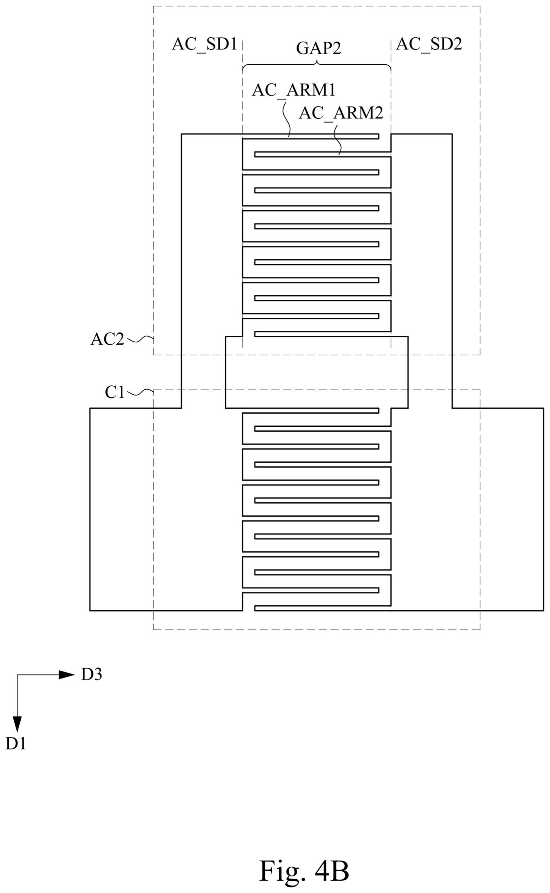

Referring to Figs. 2A, 2B, 4A, and 4B, Fig. 4A is a schematic diagram of a capacitor structure C1 and an additional capacitor structure AC1 according to an embodiment of the present disclosure, Fig. 4B is a schematic diagram of a capacitor structure C1 and an additional capacitor structure AC2 according to an embodiment of the present disclosure.

To increase the capacitance variation of capacitor structures, additional capacitor structures may be provided. Taking the first capacitor structure C1 in Fig. 2B as an example, if one wants to increase the capacitance variation of the first capacitor structure C1, an additional capacitor structure may be added to the first capacitor structure C1 to provide the structure shown in the embodiment of Fig. 4A or Fig. 4B.

In Fig. 4A, the additional capacitor structure AC1 can function as a capacitor element on the coil 120_1 through the arrangement of the second gap GAP2. The additional capacitor structure AC1 can be connected in parallel with the first capacitor structure C1, and the additional capacitor structure AC1, the first capacitor structure C1, and the coil 120_1 are integrally formed.

A dielectric layer may be formed within the second gap GAP2, and any dielectric material used to fill the dielectric layer can be any material with a dielectric constant, thereby adjusting the capacitance density of the additional capacitor structure AC1 without increasing the physical size of the additional capacitor structure AC1 itself.

By adding the additional capacitor structure AC1, the capacitive impedance of the coil turn 120_1 can be adjusted to achieve the purpose of adjusting capacitance variation.

In FIG. 4B, the additional capacitor structure AC2 comprises a plurality of first connecting arms AC_ARM1 and a plurality of second connecting arms AC_ARM2. Each of the first connecting arms AC_ARM1 extends from a first side AC_SD1 of the second gap GAP2, and each of the second connecting arms AC_ARM2 extends from a second side AC_SD2 of the second gap GAP2. The lengths of the first connecting arms AC_ARM1 and the lengths of the second connecting arms AC_ARM2 are less than the distance from the first side AC_SD1 to the second side AC_SD2 of the second gap GAP2.

The first capacitor structure C1 in Fig. 4B may correspond to the first capacitor structure C1 of the coil 120_1 in Fig. 2A. The additional capacitor structure AC2 in Fig. 4B may be arranged on the coil structure 100 in Fig. 2A and connected in parallel with the first capacitor structure C1 in Fig. 2A. Furthermore, the circuit board 110 is arranged on the first plane defined by the first direction D1 and the third direction D3, and each of the first connecting arms AC_ARM1 and each of the second connecting arms AC_ARM2 are alternately arranged along the third direction D3 on the first plane.

In summary, when the wireless charging device having the coil structure of the present disclosure is charging, the coil structure of the present disclosure can have a lower electric field strength, which means that the power of the wireless charging device is not excessively lost in the coil turns. Furthermore, the coil structure of the present disclosure can generate stronger magnetic field strength, resulting in higher charging efficiency for the wireless charging device. Moreover, due to the reduced power consumption of the coil structure of the present disclosure, the temperature rise of the coil structure can be reduced.

## Claims

1. A coil structure (100, 300), configured to apply in a field of wireless charging, the coil structure being **characterized by** comprising:
a circuit board (110, 310); and
a conductor (120, 320), arranged on the circuit board, the conductor comprising:
a plurality of coil turns (120_1~120_4, 320_1~320_4), formed around a center point (CEN1);
an input terminal (IT1), connected to one terminal of the plurality of coil turns;
an output terminal (OT1), connected to another terminal of the plurality of coil turns; and
a plurality of first capacitor structures (C1-C4, C11~C14), each of the first capacitor structures is arranged on a corresponding one of the coil turns,
wherein a distance between the first capacitor structures and the output terminal is smaller than a distance between the first capacitor structures and the input terminal, and the first capacitor structures do not overlap with the output terminal.

2. The coil structure of claim 1, wherein a first gap (GAP1) is formed on each of the plurality of turns of the coil, the plurality of first capacitor structures (C1~C4) are formed by the first gaps.

3. The coil structure according to any one of claims 1 to 2, wherein the first capacitor structures (C1~C4) and the plurality of coil turns (120_1~120_4, 320_1~320_4) are integrally formed.

4. The coil structure according to any one of claims 1 to 3, wherein the plurality of first capacitor structures (C1~C4) are aligned along a first direction (D1).

5. The coil structure according to any one of claims 1 to 4, wherein the first capacitor structures (C1~C4) have an identical capacitance value.

6. The coil structure according to any one of claims 1 to 4, wherein the first capacitor structures (C1~C4) have different capacitance values.

7. The coil structure of claim 2, wherein,
each of the first capacitor structures (C1~C4) comprises a plurality of first connecting arms (ARM1) and a plurality of second connecting arms (ARM2),
the first connecting arms (ARM1) extend from a first side (SD1) of the first gap (GAP1), the second connecting arms (ARM2) extend from a second side (SD2) of the first gap (GAP1),
each of the first connecting arms (ARM1) is spaced apart from a corresponding one of the second connecting arms (ARM2) by a first spacing (GAPA), lengths of the first connecting arms (ARM1) and the second connecting arms (ARM2) are less than a distance from the first side to the second side of the first gap, and
the first connecting arms (ARM1) and the second connecting arms (ARM2) are alternately arranged.

8. The coil structure of claim 7, wherein the circuit board is arranged on a first plane, and each of the first connecting arms (ARM1) and the second connecting arms (ARM2) are alternately arranged on the first plane.

9. The coil structure of claim 7, wherein the circuit board is arranged on a first plane, the first connecting arms (ARM1) and the second connecting arms (ARM2) are alternately arranged along a second direction (D2), and the second direction (D2) is perpendicular to the first plane.

10. The coil structure according to any one of claims 7 to 9, wherein widths of the first spacings (GAPA) are not identical.

11. The coil structure of claim 2, wherein,
each of the first capacitor structures comprises a plurality of first connecting arms (ARM1) and a plurality of second connecting arms (ARM2),
the first connecting arms (ARM1) extend from a first side (SD1) of the first gap (GAP1), the second connecting arms (ARM2) extend from a second side (SD2) of the first gap (GAP1),
each of the first connecting arms (ARM1) is spaced apart by a first spacing (GAPA), each of the second connecting arms (ARM2) is spaced apart by the first spacing (GAPA),
each of the first connecting arms (ARM1) is spaced apart from a corresponding one of the second connecting arms (ARM2) by a second spacing (GAPB), and adjacent two of the second spacings (GAPB) are not aligned along a first direction (D1).

12. The coil structure according to any one of claims 1 to 11, wherein the conductor further comprises a plurality of additional capacitor structures (AC1, AC2), each of the additional capacitor structure (AC1, AC2) is connected in parallel with a corresponding one of the first capacitor structures (C1-C4, C11~C14).

13. The coil structure of claim 12, wherein each of the additional capacitor structures (AC1, AC2) comprises a second gap (GAP2), wherein the first capacitor structures (C1-C4, C11~C14), the additional capacitor structures (AC1, AC2), and the plurality of coil turns (120_1~120_4, 320_1~320_4) are integrally formed.

14. The coil structure of claim 13, wherein,
each of the additional capacitor structures (AC2) comprises a plurality of first connecting arms (AC_ARM1) and a plurality of second connecting arms (AC_ARM2),
the first connecting arms (AC_ARM1) extend from a first side (AC_SD1) of the second gap (GAP2), the second connecting arms (AC_ARM2) extend from a second side (AC_SD2) of the second gap (GAP2), and
the first connecting arms (AC_ARM1) and the second connecting arms (AC_ARM2) are alternately arranged.

15. A wireless charging device, **characterized by** comprising:
a coil structure (100, 300), configured for wireless charging, the coil structure comprises:
a circuit board (110, 310); and
a conductor (120, 320), arranged on the circuit board, the conductor comprising:
a plurality of coil turns (120_1~120_4, 320_1~320_4), formed around a center point (CEN1);
an input terminal (IT1), connected to one terminal of the plurality of coil turns;
an output terminal (OT1), connected to another terminal of the plurality of coil turns; and
a plurality of first capacitor structures (C1-C4, C11-C14), each of the first capacitor structures is arranged on a corresponding one of the coil turns,
wherein a distance between the first capacitor structures and the output terminal is smaller than a distance between the first capacitor structures and the input terminal, and the first capacitor structures do not overlap with the output terminal.
